# FASCICULE DE BREVET EUROPEEN

(11) **EP 1 017 260 B1**
(45) Date de publication et mention de la délivrance du brevet: **24.01.2007**
(21) Numéro de dépôt: 99403151.6
(22) Date de dépôt: 15.12.1999
(51) Int. Cl.: H05K 5/02

(54) **Enregistreur de données résistant à l'écrasement et à la chaleur en cas d'accident**
Wärme- und Druck-beständiger Unfalldatenspeicher
Crush and heat resistant crash data recorder

(30) Priorité: 29.12.1998 FR 9816557
(43) Date de publication de la demande: 05.07.2000
(73) Titulaire: THALES SYSTEMES AEROPORTES S.A., 78990 Elancourt (FR)
(72) Inventeur: Canovas, Gilbert, 78370 Plaisir (FR); Vacheret, Eric, 78590 Noisy le Roi (FR)
(74) Mandataire: Plaçais, Jean Yves

(56) Documents cités:
- EP-A- 0 263 019
- EP-A- 0 550 345
- EP-A- 0 752 808
- US-A- 4 929 429

## Description

La présente invention se rapporte à un enregistreur de données résistant à l'écrasement et à la chaleur.

Elle trouve une application dans les enregistreurs installés dans des véhicules aéronautiques, spatiaux, automobiles, ferroviaires, maritimes, ou analogues, qui permettent l'acquisition et l'enregistrement de données essentielles relatives au vol, trajet, ou route en cours, en vue de leur restitution ultérieure éventuelle.

En raison du fait qu'une telle restitution de données est parfois rendue nécessaire en cas d'accident, ce genre d'enregistreur doit satisfaire à des conditions de survie extrêmement contraignantes, notamment sur le plan de la résistance à l'écrasement et à la chaleur.

De façon connue, un enregistreur de données comprend une enceinte métallique comportant une première cavité interne. Un premier isolant thermique s'étend généralement autour de la surface de la première cavité interne et définit une seconde cavité interne. Le plus souvent, un second isolant/absorbant thermique occupe la seconde cavité interne, et entoure les éléments de mémoire de données destinés à être contenus dans l'enregistreur.

Habituellement, le second isolant/absorbant thermique présente une transition de phase solide à liquide à une température élevée. Par exemple, le second isolant/absorbant est de type cire synthétique, comme dans le document EP-A-0752808.

De tels enregistreurs sont de mise en oeuvre complexe et de coût de fabrication élevé. De plus, la cire synthétique présente généralement des défauts de stabilité et de conductivité aux températures indiquées dans les standards de survivabilité à la chaleur dont les contraintes sont de plus en plus exigeantes. Par exemple, dans le document EP-A-0752808, la transition de phase solide à liquide a lieu entre 105°C et 130°C. La cire présente en outre une masse importante, ce qui engendre des contraintes supplémentaires.

De plus, à l'état liquide, la cire augmente de volume et exerce des pressions non supportables par les soudures des circuits électroniques, ce qui rend nécessaire un dispositif de fuite contrôlée de la cire hors du boîtier.

Par ailleurs, dans le document EP-A-0752808, la protection thermique fait usage de sulfate de magnésium dans une cavité annexe, emprisonnant de l'eau qui est vaporisée. Deux fusibles sont prévus pour évacuer de la vapeur d'eau avec une température de fusion de 104°C.

Dans le document EP-A-0550345, la protection thermique est obtenue à l'aide d'un matériau réservoir disposé entre le boîtier interne et une enveloppe. Le matériau réservoir est un solide doué de résistance mécanique contenant de l'eau susceptible d'être libérée sous l'action de la chaleur.

La vaporisation de l'eau engendre ici des problèmes d'évacuation de liquide et/ou d'équilibrage de pression qui sont difficiles à résoudre et rendent complexe la mise en oeuvre de la protection thermique.

La Demanderesse s'est posée le problème de remédier à ces inconvénients.

La présente invention apporte justement une solution à ce problème en proposant un enregistreur de données tel que défini dans la revendication 1.

Selon l'invention, la protection thermique a l'avantage d'utiliser une transition de phase solide à liquide sans libération de produit liquide. La vaporisation de l'eau n'est donc pas utilisée dans la protection thermique selon l'invention, ce qui élimine tout problème d'évacuation de liquide et/ou d'équilibrage de pression.

De même, selon l'invention, il n'y a pas besoin d'enceinte étanche ou de protection vis à vis des produits utilisés, car les matériaux utilisés selon l'invention ne sont pas agressifs. Il en résulte une mise en oeuvre de grande simplicité avec une mise en place des cartes à mémoires aisée, ce qui réduit d'autant les coûts.

L'enregistreur de données de l'invention peut en outre comporter les caractéristiques définies dans l'une des revendications 2 et 3.

De façon surprenante, la Demanderesse a observé que A le matériau de l'isolant/absorbant thermique commercialisé par la Société 3M sous la référence 3M INTERAM E-5A, habituellement utilisé pour la protection passive contre l'incendie sur des câbles électriques ou sur des structures en acier peut aussi servir à la protection des éléments de mémoire d'un enregistreur de données.

De plus, la Demanderesse a étudié et vérifié que les propriétés thermiques de ce matériau sur le plan de l'isolation et de l'absorption de la chaleur sont parfaitement conservées jusqu'à une température élevée de l'ordre de 220 °C, qui est nettement supérieure à la température limite de fonctionnement normal des éléments de mémoire généralement utilisés dans ce type d'enregistreur de données.

Les moyens formant isolant/absorbant de plus comporter une pluralité de matelas, comme défini dans l'une des revendications 5 à 7.

Par exemple, le matelas creusé est placé entre au moins deux matelas.

Des caractéristiques additionnelles et/ou complémentaires de l'invention sont définies dans les revendications 8 à 12.

D'autres caractéristiques et avantages de l'invention apparaîtront à la lumière de la description détaillée ci-après et des dessins dans lesquels :
- la figure 1 est une vue en perspective de l'enceinte et du premier isolant thermique selon l'invention;
- la figure 2 est une vue en éclaté des différents éléments constitutifs d'un enregistreur selon l'invention; et
- la figure 3 représente des courbes illustrant le flux de chaleur absorbé par le second isolant/absorbant de l'invention en fonction de la température.

Les dessins annexés comportent, à de nombreux titres, des informations de caractère certain. Ils pourront en conséquence, non seulement servir à faire mieux comprendre la description détaillée ci-après, mais aussi contribuer à la définition de l'invention, le cas échéant.

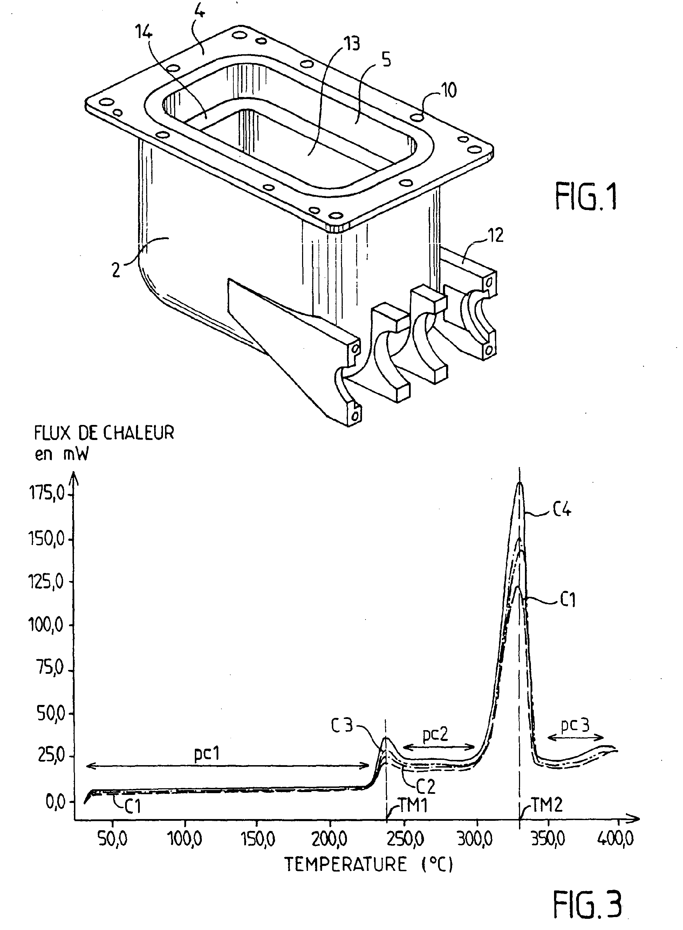

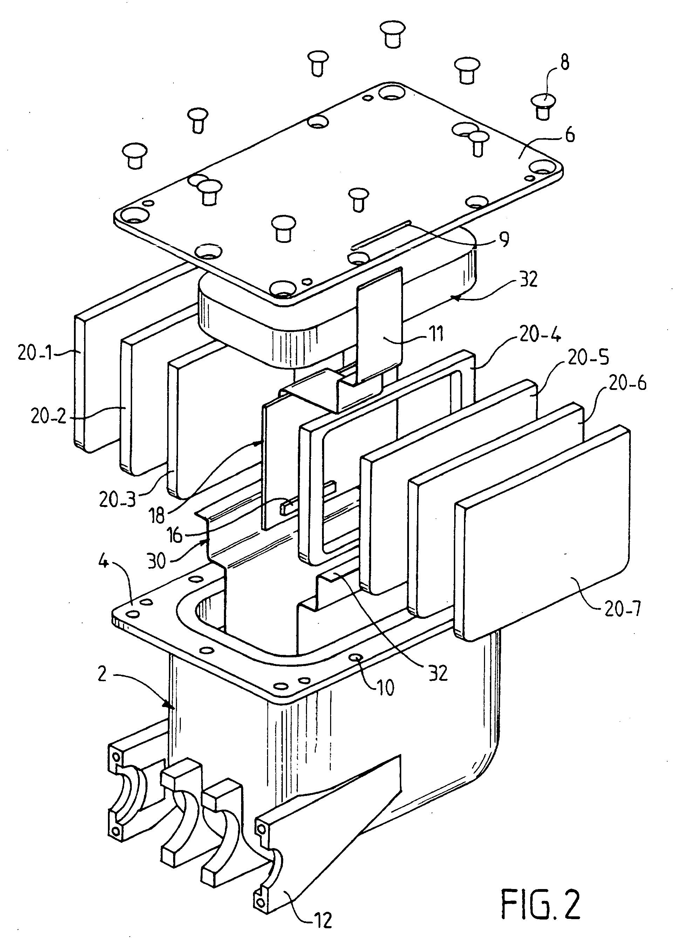

En référence aux figures 1 et 2, l'enregistreur de la présente invention comprend un boîtier au enceinte métallique 2, relativement petit en taille, et relativement léger en poids préférence, le boîtier 2 est de dimensions compatibles à celles d'un boîtier de type 1/2-ATR, afin d'être monté sur un support communément utilisé en aéronautique.

Il est à remarquer que l'enregistreur peut être utilisé, non seulement en milieu aéronautique, mais aussi pour des véhicules maritimes, ferroviaires, automobiles, spatiaux ou analogues.

Le boîtier métallique 2 définit une première cavité interne 5.

Par exemple, le boîtier métallique 2 est construit en acier ou une autre matière qui présente une densité relativement faible, une conductance thermique relativement élevée et une résistance relativement élevée à l'écrasement et à la pénétration.

Le boîtier métallique 2 est destiné à être fermé par un couvercle 6, également en matière métallique et, de préférence, en acier.

Le bord libre du boîtier ouvert 2 comprend des lèvres plates 4 sur lesquelles sont ménagés des trous de fixation 10. Le couvercle 6 est destiné à être assemblé aux lèvres 4 au moyen de vis 8 propres à s'insérer dans les trous de fixation 10 des lèvres plates. D'autres moyens de fixation conventionnels sont susceptibles d'être appliqués.

En pratique, la cavité interne 5 définie par le boîtier 2 est de forme parallélépipédique, avec des angles arrondis.

Avantageusement, le boîtier 2 comprend un appendice 12 solidaire du boîtier 2. Cet appendice est destiné à supporter une balise acoustique maritime (non représentée). Par exemple, le support 12 comprend 4 mâchoires circulaires destinées à recevoir une balise cylindrique.

Une garniture thermique 14 est logée à l'intérieur de la cavité 5. Une telle garniture thermique constitue une première barrière thermique.

La garniture thermique 14, d'une épaisseur de l'ordre de 2 à 3 cm, forme une cavité 13 s'étendant vers l'intérieur.

La garniture thermique 14 est de préférence une structure unitaire, formée d'une matière solide moulée. Une telle garniture thermique constitue un bon isolant thermique, c'est-à-dire qu'il présente une conductivité thermique faible et une densité relativement faible.

En pratique, la garniture thermique 14 est une combinaison de matière fibreuse et de particules très fines.

Par exemple, la garniture 14 est le produit commercialisé sous la référence MIN-K de type 1303 par la Société THERMAL CERAMICS, ou MICROTHERM.

Les éléments de mémoire 16 sont par exemple connectés sur une carte à circuit imprimé 18 de type double face.

En pratique, les éléments de mémoire 16 sont de type statique, par exemple EEPROM. La carte de circuit imprimé 18 comprend un connecteur (non représenté) permettant la connexion d'une nappe de fils 11 à un système électronique extérieur (non représenté) via une fente 9 ménagée dans le couvercle 6.

Avantageusement, les éléments 16 de la carte de circuits imprimés 18 sont protégés de l'eau, à l'aide d'un vernis approprié.

Selon un mode de réalisation de l'invention, pour permettre d'obtenir un degré élevé de protection thermique, la carte de circuit imprimé 18 est en outre logée dans une pile de matelas, individualisés en 20-1 à 20-7, et dont l'un 20-4 est creusé au format de la carte 18.

Pour simplifier, seule une carte de circuits imprimés est logée dans l'enceinte. Bien évidemment, selon les applications, par exemple en maritime, l'enregistreur peut contenir plusieurs cartes qui seront alors protégées selon l'invention comme la carte 18.

Par exemple, les matelas 20 sont de forme générale parallélépipédique. Les dimensions des matelas sont sensiblement supérieures à celles de la carte de circuits imprimés 18.

Selon l'invention, les matelas 20 sont constitués d'un matériau de type isolant/absorbant thermique contenant des fibres céramiques et une matière endothermique inorganique.

En pratique, ce matériau est commercialisé par la Société 3M sous la référence 3M INTERAM E-5A, avec une alternative E-5A-3 (7,6mm) ou E-5A-4 (10,2mm) selon l'épaisseur des matelas.

De façon surprenante, la Demanderesse a observé qu'un tel matériau habituellement utilisé pour la protection passive contre l'incendie sur des câbles électriques ou sur des structures en acier peut aussi servir à la protection des éléments de mémoire d'un enregistreur de données.

De plus, La Demanderesse a étudié et observé que les propriétés thermiques de ce matériau sur le plan de l'isolation et de l'absorption de la chaleur sont parfaitement conservées jusqu'à une température élevée de l'ordre de 220 °C correspondant à une température nettement supérieure à la température limite de fonctionnement normal des éléments de mémoire qui sont généralement utilisés dans ce type d'enregistreur de données.

En référence à la figure 3, on a représenté quatre courbes C1 à C4 illustrant le flux de chaleur absorbé par un matelas de type E-5A-3 en fonction de la température.

La courbe C1 illustre le flux thermique absorbé par un matelas E-5A-3 en fonction de la température, sans traitement spécial au préalable.

La courbe C2 illustre le flux thermique absorbé par un matelas E-5A-3 en fonction de la température, après avoir été soumis pendant 24 heures à une température de 95°C.

La courbe C3 illustre graphiquement le flux thermique absorbé par un matelas E-5A-3 en fonction de la température, après avoir été soumis pendant 240 heures à une température de 95°C.

La courbe C4 illustre graphiquement le flux thermique absorbé par un matelas E-5A-3 en fonction de la température, après avoir été soumis pendant 600 heures à une température de 95°C.

Chaque courbe est caractérisée par une première plage de température PC1, allant de quelques °C à 220°C, dans laquelle le flux de chaleur absorbé par le matériau 20 est relativement constant. Cette constante montre que le matériau est inerte dans cette plage PC1.

Sur chaque courbe, on observe un premier pic TM1 autour de 220 à 240°C, avec un accroissement important de l'énergie thermique absorbée.

Chaque courbe est caractérisée en outre par une seconde plage de température PC2, allant de quelques 250°C à 300°C, dans laquelle le flux de chaleur absorbé par le matériau 20 est relativement constant.

On observe aussi un second pic TM2 autour de 330°C, avec un accroissement important de l'énergie thermique absorbée.

Enfin, on observe une troisième plage PC3 allant de 350°C et au delà, dans laquelle l'énergie absorbée est relativement constante.

On fait à nouveau référence aux figures 1 et 2.

Les matelas 20 sont rangés en pile, les uns contre les autres, en parallèle avec les grandes faces latérales du boîtier 2. Le matelas 20-4 est creusé au format de la carte 18 supportant les éléments de mémoire, de sorte que ladite carte 18 est logée dans ledit matelas ainsi creusé.

Avantageusement, le matelas 20-4 ainsi creusé est placé à l'intérieur de la pile. Par exemple, en référence à la figure 2, le matelas 20-4 est placé entre les trois matelas 20-1 à 20-3, et les trois matelas 20-5 à 20-7.

Très avantageusement, la pile de matelas est enveloppée dans une enveloppe en matière plastique 30, par exemple, en polycarbonate. Les bords libres 32 de l'enveloppe sont propres à déborder de l'enceinte après insertion de la pile dans l'enceinte afin de constituer des languettes facilitant l'extraction/insertion de la pile de matelas.

De plus, cette enveloppe en matière plastique assure une compression lors de l'insertion des matelas dans l'enceinte, ainsi qu'une compression résiduelle après insertion.

Enfin, un couvercle en matière isolante 32 recouvre la pile de matelas ainsi insérée dans l'enceinte avant application du couvercle 6 sur les lèvres 4 du boîtier métallique 2.

Le couvercle en matière isolante 32 est construit avec la même matière que la garniture thermique 14. Ce couvercle couvre la face ouverte du boîtier contenant la pile de matelas, de manière à couvrir complètement le boîtier et fermer ainsi le boîtier à l'aide du couvercle 6.

Grâce à l'invention, l'enregistreur vérifie les exigences indiquées dans le document TSO C-124a (Technical Standard Order) délivré par l'Administration américaine (FAA), et qui concernent les tests de survivabilité des enregistreurs en cas d'accident.

L'épaisseur totale de l'ensemble formé par la garniture thermique 14 et les matelas 20 ainsi que le volume occupé par lesdits matelas déterminent le degré de la protection thermique conférée.

Dans le commerce, les matelas E-5A sont habituellement vendus avec une feuille d'aluminium sur l'une des faces. La Demanderesse s'est aperçue qu'il est préférable de retirer cette feuille d'aluminium.

## Revendications

1. Enregistreur de données résistant à l'écrasement et à la chaleur en cas d'accident, comprenant :
- une enceinte métallique (2) comportant une première cavité interne (5);
- des premiers moyens formant un isolant thermique (14) propres à s'étendre autour de la surface de la première cavité interne (5), et définissant une seconde cavité interne (13);
- des seconds moyens formant un isolant/absorbant thermique (20), propres à occuper au moins une partie de la seconde cavité interne (13) et à entourer des éléments (16) de mémoire de données, les seconds moyens formant un isolant/absorbant thermique présentant une transition de phase solide à liquide à haute température;
les seconds moyens formant un isolant/absorbant thermique (20) étant constitués d'un matériau contenant des fibres céramiques et une matière endothermique inorganique et la transition de phase solide à liquide s'effectuant sans libération de produit liquide; **caractérisé en ce que** les seconds moyens formant un isolant/absorbant thermique (20) sont commercialisés par la Société 3M sous la référence 3M INTERAM E-5A.

2. Enregistreur selon la revendication 1, **caractérisé en ce que** les seconds moyens formant isolant/absorbant thermique (20) conservent leur propriété absorbante sur une gamme de température allant de quelques degrés Celsius jusqu'à une température élevée de l'ordre de 220°C.

3. Enregistreur selon la revendication 2, **caractérisé en ce que** les seconds moyens formant un isolant/absorbant thermique (20) conservent leur propriété absorbante lorsqu'ils sont soumis à haute température pendant une durée d'au moins deux centaines d'heures.

4. Enregistreur selon l'une quelconque des précédentes revendications, **caractérisé en ce qu'**il est destiné à être installé dans un véhicule aéronautique, automobile, ferroviaire, maritime, ou spatial.

5. Enregistreur selon la revendication 1, **caractérisé en ce que** les seconds moyens formant un isolant/absorbant thermique (20) comprennent une pluralité de matelas (20-1 à 20-7) d'épaisseur prédéterminée, disposés en piles les uns à côté des autres, au moins l'un des matelas (20-4) étant creusé au format de la carte (18) supportant les éléments de mémoire (16), de sorte que ladite carte (18) est logée dans ledit matelas 20-4) ainsi creusé, le matelas ainsi creusé étant placé à l'intérieur de la pile.

6. Enregistreur selon la revendication 5, **caractérisé en ce que** le matelas creusé (20-4) est placé entre 3 matelas de chaque côté.

7. Enregistreur selon l'une des revendications précédentes, **caractérisé en ce que** la pile de matelas est enveloppée dans une enveloppe (30) en matière plastique, les extrémités libres (32) de l'enveloppe (30) étant propres à déborder de l'enceinte après insertion de la pile de matelas dans l'enceinte (2), afin de constituer des languettes facilitant l'extraction/insertion de la pile de matelas dans l'enceinte, l'enveloppe assurant en outre une compression lors de l'insertion des matelas dans l'enceinte ainsi qu'une compression résiduelle après insertion.

8. Enregistreur selon l'une des revendications précédentes, **caractérisé en ce que** l'enceinte (2) comprend un appendice solidaire de ladite enceinte et comprenant des moyens formant support (12) propres à supporter une balise.

9. Enregistreur selon l'une des revendications précédentes, **caractérisé en ce que** les éléments de mémoire (16) sont de type statique.

10. Enregistreur selon l'une des revendications précédentes, **caractérisé en ce que** les premiers moyens formant isolant thermique (14) sont constitués d'un matériau de type isolant passif, de type MIN-K ou MICROTHERM.

11. Enregistreur selon l'une des revendications précédentes, **caractérisé en ce que** l'enceinte (2) est en acier.

12. Enregistreur selon l'une des revendications précédentes, **caractérisé en ce que** les matelas sont non recouverts de feuille d'aluminium.

## Claims

1. Crush- and heat-resistant crash data recorder, comprising:
a metal enclosure (2) comprising a first internal cavity (5);
- first means forming a thermal insulant (14), able to extend around the surface of the first internal cavity (5), and defining a second internal cavity (13);
- second means forming a thermal insulant/absorbent (20), able to occupy at least a part of the second internal cavity (13) and to surround data memory elements (16), the second means forming a thermal insulant/absorbent exhibiting a solid to liquid phase transition at high temperature;
the second means forming a thermal insulant/absorbent (20) being constituted of a material containing ceramic fibres and an inorganic endothermic substance and the solid to liquid phase transition occurring without release of liquid product, **characterized in that** the second means forming a thermal insulant/absorbent (20) are marketed by the company 3M under the reference 3M INTERAM E-5A.

2. Recorder according to Claim 1, **characterized in that** the second means forming thermal insulant/absorbent (20) retain their absorbent property over a temperature range of from a few degrees Celsius to an elevated temperature of the order of 220°C.

3. Recorder according to Claim 2, **characterized in that** the second means forming a thermal insulant/absorbent (20) retain their absorbent property when they are subjected to a high temperature for a duration of at least two hundred hours.

4. Recorder according to any one of the preceding claims, **characterized in that** it is intended to be installed in an aeronautical, automotive, railway, maritime, or space vehicle.

5. Recorder according to Claim 1, **characterized in that** the second means forming a thermal insulant/absorbent (20) comprise a plurality of mats (20-1 to 20-7) of predetermined thickness, piled in stacks one alongside another, at least one of the mats (20-4) being hollowed out to the format of the card (18) supporting the memory elements (16), so that the said card (18) is accommodated in the said mat (20-4) thus hollowed out, the mat thus hollowed out being placed inside the stack.

6. Recorder according to Claim 5, **characterized in that** the hollowed-out mat (20-4) is placed between three mats on each side.

7. Recorder according to one of the preceding claims, **characterized in that** the stack of mats is enveloped in a plastic envelope (30), the free ends (32) of the envelope (30) being able to overhang the enclosure after insertion of the stack of mats into the enclosure (2), so as to constitute tabs facilitating the extraction/insertion of the stack of mats into the enclosure, the envelope furthermore ensuring compression during the insertion of the mats into the enclosure as well as a residual compression after insertion.

8. Recorder according to one of the preceding claims, **characterized in that** the enclosure (2) comprises an appendage integral with the said enclosure and comprising support-forming means (12) able to support a beacon.

9. Recorder according to one of the preceding claims, **characterized in that** the memory elements (16) are of static type.

10. Recorder according to one of the preceding claims, **characterized in that** the first means forming a thermal insulant (14) are constituted from a material of passive insulating type, of MIN-K or MICROTHERM type.

11. Recorder according to one of the preceding claims, **characterized in that** the enclosure (2) is made of steel.

12. Recorder according to one of the preceding claims, **characterized in that** the mats are not covered with aluminium foil.

## Patentansprüche

1. Datenregistriergerät, das bei Unfall Zusammendrücken und Hitze standhält, umfassend:
- einen Metalleinschluss (2), der einen ersten Innenhohlraum (5) aufweist,
- erste Mittel, die eine Wärmeisolierung (14) bilden, die sich um die Fläche des ersten Innenhohlraums (5) erstrecken und einen zweiten Innenhohlraum (13) definieren kann,
- zweite Mittel, die ein Wärmeisolations-/Wärmeabsorptionsmittel (20) bilden, das mindestens einen Teil des zweiten Innenhohlraums (13) belegen und Datenspeicherelemente (16) umgeben kann, wobei die zweiten Mittel ein Wärmeisolations-/Wärmeabsorptionsmittel bilden, das bei hoher Temperatur einen Phasenübergang von fest zu flüssig aufweist,
**dadurch gekennzeichnet, dass** die zweiten Mittel, die ein Wärmeisolations-/Wärmeabsorptionsmittel (20) bilden, aus einem Werkstoff bestehen, der Keramikfasern und ein endothermes anorganisches Material enthält, und wobei der Phasenübergang von fest zu flüssig ohne Freisetzen von Flüssigprodukt erfolgt, **dadurch gekennzeichnet, dass** die zweiten Mittel, die ein Wärmeisolations-/Wärmeabsorptionsmittel (20) bilden, von der Firma 3M unter der Referenz 3M INTERAM E-5A vermarktet werden.

2. Datenregistriergerät nach Anspruch 1, **dadurch gekennzeichnet, dass** die zweiten Mittel, die ein Wärmeisolations-/Wärmeabsorptionsmittel (20) bilden, ihre absorbierende Eigenschaft in einem Temperaturbereich von einigen Grad Celsius bis zu einer hohen Temperatur in der Größenordnung von 220 °C behalten.

3. Datenregistriergerät nach Anspruch 2, **dadurch gekennzeichnet, dass** die zweiten Mittel, die ein Wärmeisolations-/Wärmeabsorptionsmittel (20) bilden, ihre absorbierende Eigenschaft behalten, wenn sie während einer Dauer von mindestens zweihundert Stunden einer hohen Temperatur unterworfen werden.

4. Datenregistriergerät nach einem der vorhergehenden Ansprüche, **dadurch gekennzeichnet, dass** es dazu bestimmt ist, in einem Luft-, Automobil-, Bahn-, See- oder Raumfahrzeug installiert zu werden.

5. Datenregistriergerät nach Anspruch 1, **dadurch gekennzeichnet, dass** die zweiten Mittel, die ein Wärmeisolations-/Wärmeabsorptionsmittel (20) bilden, mehrere Matratzen (20-1 bis 20-7) mit vorbestimmter Stärke aufweisen, die in Stapeln nebeneinander angeordnet sind, wobei mindestens eine der Matratzen (20-4) im Format der Karte (18), die die Speicherelemente (16) trägt, ausgehöhlt ist, so dass die Karte (18) in der ausgehöhlten Matratze (20-4) untergebracht ist und die so ausgehöhlte Matratze im Inneren des Stapels angeordnet ist.

6. Datenregistriergerät nach Anspruch 5, **dadurch gekennzeichnet, dass** die ausgehöhlte Matratze (20-4) zwischen 3 Matratzen zu jeder Seite angeordnet ist.

7. Datenregistriergerät nach einem der vorhergehenden Ansprüche, **dadurch gekennzeichnet, dass** der Matratzenstapel von einem Mantel (30) aus Kunststoff umgeben ist, wobei die freien Enden (32) des Mantels (30) aus dem Einschluss nach dem Einfügen des Matratzenstapels in den Einschluss (2) überstehen können, um Zungen zu bilden, die das Herausziehen/Einfügen des Matratzenstapels aus dem/in den Einschluss erleichtern, wobei der Mantel ferner ein Zusammendrücken beim Einfügen der Matratzen in den Einschluss sowie ein Restzusammendrücken nach dem Einfügen sicherstellt.

8. Datenregistriergerät nach einem der vorhergehenden Ansprüche, **dadurch gekennzeichnet, dass** der Einschluss (2) einen fest mit dem Einschluss verbundenen Ansatz sowie Mittel aufweist, die einen Träger (12) bilden, der eine Bake tragen kann.

9. Datenregistriergerät nach einem der vorhergehenden Ansprüche, **dadurch gekennzeichnet, dass** die Speicherelemente (16) des statischen Typs sind.

10. Datenregistriergerät nach einem der vorhergehenden Ansprüche, **dadurch gekennzeichnet, dass** die ersten Mittel, die eine Wärmeisolierung (14) bilden, aus einem Werkstoff des passiv isolierenden Typs, des Typs MIN-K oder MICROTHERM bestehen.

11. Datenregistriergerät nach einem der vorhergehenden Ansprüche, **dadurch gekennzeichnet, dass** der Einschluss (2) aus Stahl besteht.

12. Datenregistriergerät nach einem der vorhergehenden Ansprüche, **dadurch gekennzeichnet, dass** die Matratzen nicht mit Aluminiumblatt überzogen sind.
